(19)

Europäisches
Patentamt
European
Patent Office
Office européen
des brevets

(11) **EP 4 328 678 A1**

(12) **EUROPEAN PATENT APPLICATION**
published in accordance with Art. 153(4) EPC

(43) Date of publication:
**28.02.2024 Bulletin 2024/09**

(21) Application number: **22814862.3**

(22) Date of filing: **08.04.2022**

(51) International Patent Classification (IPC):
**G05B 15/02** (2006.01)

(52) Cooperative Patent Classification (CPC):
**G05B 15/02; G05B 19/418; G06F 30/20;
H04W 4/02**

(86) International application number:
**PCT/CN2022/085700**

(87) International publication number:
**WO 2022/252815 (08.12.2022 Gazette 2022/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **02.06.2021 CN 202110614552**

(71) Applicant: **Huawei Technologies Co., Ltd.
Shenzhen, Guangdong 518129 (CN)**

(72) Inventors:
• **LI, Zhijie
Shenzhen, Guangdong 518129 (CN)**
• **LIAO, Yi
Shenzhen, Guangdong 518129 (CN)**

(74) Representative: **Isarpatent
Patent- und Rechtsanwälte
Barth Hassa Peckmann & Partner mbB
Friedrichstraße 31
80801 München (DE)**

(54) **METHOD FOR CONFIGURING DEVICE INFORMATION OF HOME DEVICE, AND ELECTRONIC DEVICE**

(57)    A method for configuring device information of a home device, and an electronic device are provided. The method for configuring device information of a home device includes: using a first three-dimensional model as a template model of locations of home devices based on a characteristic that layouts of a plurality of houses are the same or layouts of a plurality of houses are symmetric to each other; obtaining, by an installation and maintenance device, a plurality of pieces of location information of a plurality of home devices installed in a second house, and generating, by the installation and maintenance device, a second three-dimensional model based on the plurality of pieces of location information of the plurality of home devices in the 2nd house; and if the first three-dimensional model and the second three-dimensional model are successfully matched, automatically configuring, by the installation and maintenance device, device information of a home device in the 2nd house based on device information of a home device in a 1st house. A fit-out worker does not need to configure device information of each home device in each house one by one, and device information of home devices in one or more houses can be configured together. This improves efficiency of an installation and maintenance process.

An installation and maintenance device receives a plurality of pieces of first location information of a plurality of first home devices installed in a first house, where first device information has been configured for the first home device — 501

The installation and maintenance device generates a first three-dimensional model based on the plurality of pieces of first location information, where the first three-dimensional model includes a plurality of first location nodes that are in a correspondence with the pieces of first location information — 502

The installation and maintenance device receives a plurality of pieces of second location information of a plurality of second home devices installed in a second house — 503

The installation and maintenance device generates a second three-dimensional model based on the plurality of pieces of second location information, where the second three-dimensional model includes a plurality of second location nodes that are in a correspondence with the pieces of second location information — 504

The installation and maintenance device performs matching on the first three-dimensional model and the second three-dimensional model to obtain a matching result, where the matching result includes a first target location node and a second target location node that are successfully matched — 505

Configure, based on the first device information of the first home device corresponding to the first target location node, second device information of the second home device corresponding to the second target location node — 506

FIG. 5

EP 4 328 678 A1

**Description**

This application claims priority to Chinese Patent Application No. 202110614552.1, filed with the China National Intellectual Property Administration on June 2, 2021 and entitled "METHOD FOR CONFIGURING DEVICE INFORMATION OF HOME DEVICE, AND ELECTRONIC DEVICE", which is incorporated herein by reference in its entirety.

**TECHNICAL FIELD**

This application relates to the field of smart home technologies, and in particular, to a method for configuring device information of a home device, and an electronic device.

**BACKGROUND**

A smart home connects various home devices (such as an illumination device, a security device, a home appliance, and the like) by using internet of things technologies, and implements new home life experience through networked comprehensive intelligent control and management. For example, different application modes of the smart home are implemented through collaboration of a plurality of home devices. To implement collaboration of the plurality of home devices, device information of the home devices needs to be set in an early stage of fit-out. As a result, a control device can identify the different home devices based on the device information of the home devices, to control the plurality of home devices to collaborate with each other.

Currently, a fit-out worker needs to manually set device information of each home device one by one. However, there may be hundreds of home devices in one house. Therefore, when the fit-out worker fits out dozens of or even hundreds of houses, a workload of manually setting device information of each home device one by one by the fit-out worker is heavy, and efficiency of installation and maintenance is low.

**SUMMARY**

Embodiments of this application provide a method for configuring device information of a home device, and an electronic device, to improve efficiency of configuration of device information of a home device.

According to a first aspect, an embodiment of this application provides a method for configuring device information of a home device. The method is applied to an installation and maintenance device. The method may include the following steps. First, the installation and maintenance device receives a plurality of pieces of second location information of a plurality of second home devices installed in a second house. Then, the installation and maintenance device generates a second three-dimensional model based on the plurality of pieces of second location information. The second three-dimensional model includes a plurality of second location nodes that are in a correspondence with the pieces of second location information. Next, the installation and maintenance device performs matching on a first three-dimensional model and the second three-dimensional model to obtain a matching result. The matching result includes a first target location node and a second target location node that are successfully matched. The first three-dimensional model is generated based on a plurality of pieces of first location information of a plurality of first home devices in a first house, and the first three-dimensional model is a template model of locations of home devices. First device information has been configured for the first home devices. The first three-dimensional model includes a plurality of first location nodes that are in a correspondence with the pieces of first location information. A layout of the second house is the same as a layout of the first house, or a layout of the second house is symmetric to a layout of the first house. Finally, the installation and maintenance device automatically configures, based on the first device information of the first home device corresponding to the first target location node, second device information of the second home device corresponding to the second target location node. In this embodiment, a first three-dimensional model of a first house is a template model of locations of home devices. When another house is fit out, the installation and maintenance device obtains a plurality of pieces of location information of a plurality of home devices installed in a second house based on a characteristic that layouts of a plurality of houses are the same or layouts of a plurality of houses are symmetric to each other. Then, the installation and maintenance device generates a second three-dimensional model based on the plurality of pieces of location information of the plurality of home devices in the second house. If the first three-dimensional model and the second three-dimensional model are successfully matched, the installation and maintenance device automatically configures device information of the home devices in the second house based on device information of home devices in the first house. A fit-out worker does not need to configure device information of each home device in each house one by one, and device information of home devices in one or more houses can be configured together. This improves efficiency of an installation and maintenance process.

In an optional implementation, that the installation and maintenance device configures, based on the first device information of the first home device corresponding to the first target location node, second device information of the

EP 4 328 678 A1

second home device corresponding to the second target location node may specifically include: The installation and maintenance device copies the first device information of the first home device corresponding to the first target location node, to obtain first device information backup, and uses the first device information backup as the second device information of the second home device corresponding to the second target location node.

In an optional implementation, before matching is performed on the first three-dimensional model and the second three-dimensional model, the method further includes:

The installation and maintenance device receives the plurality of pieces of first location information of the plurality of first home devices installed in the first house, and generates the first three-dimensional model based on the plurality of pieces of first location information.

In an optional implementation, the first device information includes a first installation location identifier. The first installation location identifier is used to describe an installation location of the first home device. The method further includes: The installation and maintenance device displays the first three-dimensional model and a first installation location identifier corresponding to each first location node in the first three-dimensional model. In this embodiment, because the first three-dimensional model is a template model of spatial locations of home devices, the installation and maintenance device successfully obtains the pieces of first location information of all the first home devices in the first house, to ensure accuracy of the first three-dimensional model. In this embodiment, the first three-dimensional model is visualized, to help the fit-out worker verify the first location node in the first three-dimensional model.

In an optional implementation, there are a plurality of second three-dimensional models. Each second three-dimensional model corresponds to a second house. When the matching result further includes a location node that fails to be matched, the method further includes: generating prompt information. The prompt information includes an identifier of the second house. In this embodiment, matching is performed on the first three-dimensional model of the first house and second three-dimensional models of a plurality of second houses together. Therefore, if a matching result indicates that there is a location node that fails to be matched, the installation and maintenance device generates prompt information (also referred to as "first prompt information"). The prompt information is used to notify a fit-out worker that there is a second home device, in the second house, for which device information fails to be configured, and the first prompt information includes a house identifier, so that the fit-out worker can perform a targeted check.

In an optional implementation, the method further includes: The installation and maintenance device responds to a confirmation operation performed by the fit-out worker on the prompt information, and displays the first three-dimensional model, the second three-dimensional model, and the location node that fails to be matched, based on the confirmation operation. In this embodiment, the installation and maintenance device visualizes the first three-dimensional model, the second three-dimensional model, and the matching result, so that the fit-out worker checks the location node that fails to be matched, to ensure that second device information of all the second home devices in the second house is successfully configured.

In an optional implementation, the method further includes: The installation and maintenance device displays a first house model and a second house model. The first house model includes the first three-dimensional model, and the second house model includes the second three-dimensional model. In this embodiment, the installation and maintenance device displays the first house model and the second house model, so that the fit-out worker can more intuitively observe a location of the second home device in the second house.

In an optional implementation, the method further includes: The installation and maintenance device responds to a first rotation operation performed by the fit-out worker on the first house model, and displays the first house model from different angles of view based on the first rotation operation; or the installation and maintenance device responds to a second rotation operation performed by the fit-out worker on the second house model, and displays the second house model from different angles of view based on the second rotation operation. In this embodiment, the installation and maintenance device may display the first house model and the second house model from different angles of view, so that the fit-out worker can more intuitively observe the location of the second home device in the second house.

In an optional implementation, the second location information and the first location information are obtained in at least one of the following locating manners: UWB, ultrasonic, Wi-Fi, Bluetooth, RFID, and ZigBee.

In an optional implementation, the first device information indicates the fit-out worker to configure a first home device collaboration scenario for the first house. The first home device collaboration scenario includes any one of a guest reception mode, a movie watching mode, an away mode, a sleep mode, a karaoke mode, a kids mode, a focus mode, a home mode, a work mode, or an elderly care mode. The any one mode includes collaboration of the plurality of first home devices. When or after the second device information of the second home device corresponding to the second target location node is configured based on the first device information of the first home device corresponding to the first target location node, the method may further include: configuring a second home device collaboration scenario for the second house based on the first home device collaboration scenario. The second home device collaboration scenario is the same as or similar to the first home device collaboration scenario. In this embodiment, the first device information is used to differentiate different home devices in the first house, to implement collaboration of a plurality of home devices. The second device information is used to differentiate different home devices in the second house, to implement collaboration of a plurality of home devices.

In an optional implementation, the method is applied to any one of a personal computer, a mobile phone, a tablet, and a terminal device dedicated to installation and maintenance.

In an optional implementation, the first home device and the second home device include at least two of a smart power strip, an electronic door lock, a smart speaker, an illumination device, a smart home appliance, a curtain control device, a home gateway, a projection device, a home robot, a sensing device, a gas control device, a smart alarm device, a smart electrical meter, and a smart water meter.

According to a second aspect, an embodiment of this application provides an installation and maintenance device. The installation and maintenance device includes a receiving module and a processing module.

The receiving module is configured to receive a plurality of pieces of second location information of a plurality of second home devices installed in a second house.

The processing module is configured to generate a second three-dimensional model based on the plurality of pieces of second location information. The second three-dimensional model includes a plurality of second location nodes that are in a correspondence with the pieces of second location information.

The processing module is further configured to perform matching on a first three-dimensional model and the second three-dimensional model to obtain a matching result. The matching result includes a first target location node and a second target location node that are successfully matched. The first three-dimensional model is generated based on a plurality of pieces of first location information of a plurality of first home devices in a first house. First device information has been configured for the first home devices. The first three-dimensional model includes a plurality of first location nodes that are in a correspondence with the pieces of first location information. A layout of the second house is the same as a layout of the first house, or a layout of the second house is symmetric to a layout of the first house.

The processing module is further used to configure, based on the first device information of the first home device corresponding to the first target location node, second device information of the second home device corresponding to the second target location node.

In an optional implementation, the processing module is further specifically configured to: copy the first device information of the first home device corresponding to the first target location node, to obtain first device information backup, and use the first device information backup as the second device information of the second home device corresponding to the second target location node.

In an optional implementation, the receiving module is further configured to receive the plurality of pieces of first location information of the plurality of first home devices installed in the first house.

The processing module is further configured to generate the first three-dimensional model based on the plurality of pieces of first location information.

In an optional implementation, the first device information includes a first installation location identifier. The first installation location identifier is used to describe an installation location of the first home device. The installation and maintenance device further includes a display module.

The display module is configured to display the first three-dimensional model and a first installation location identifier corresponding to each first location node in the first three-dimensional model.

In an optional implementation, there are a plurality of second three-dimensional models. Each second three-dimensional model corresponds to a second house. When the matching result further includes a location node that fails to be matched, the processing module is further configured to generate prompt information. The prompt information includes an identifier of the second house.

In an optional implementation, the processing module is further configured to respond to a confirmation operation performed by the fit-out worker on the prompt information.

The display module is configured to display the first three-dimensional model, the second three-dimensional model, and the location node that fails to be matched, based on the confirmation operation.

In an optional implementation, the display module is further configured to display a first house model and a second house model. The first house model includes the first three-dimensional model, and the second house model includes the second three-dimensional model.

In an optional implementation, the processing module is further configured to: respond to a first rotation operation performed by the fit-out worker on the first house model, and display the first house model from different angles of view based on the first rotation operation; or the processing module is further configured to: respond to a second rotation operation performed by the fit-out worker on the second house model, and display the second house model from different angles of view based on the second rotation operation.

In an optional implementation, the second location information and the first location information are obtained in at least one of the following locating manners: ultra-wideband UWB, ultrasonic, wireless fidelity Wi-Fi, Bluetooth, radio frequency identification RFID, and ZigBee.

In an optional implementation, the first device information indicates the fit-out worker to configure a first home device collaboration scenario for the first house. The first home device collaboration scenario includes any one of a guest reception mode, a movie watching mode, an away mode, a sleep mode, a karaoke mode, a kids mode, a focus mode, a home mode, a work mode, or an elderly care mode. The any one mode includes collaboration of the plurality of first home devices. The processing module is further used to configure a second home device collaboration scenario for the second house based on the first home device collaboration scenario. The second home device collaboration scenario is the same as or similar to the first home device collaboration scenario.

In an optional implementation, the method is applied to any one of a personal computer, a mobile phone, a tablet, and a terminal device dedicated to installation and maintenance.

In an optional implementation, the first home device and the second home device include at least two of a smart power strip, an electronic door lock, a smart speaker, an illumination device, a smart home appliance, a curtain control device, a home gateway, a projection device, a home robot, a sensing device, a gas control device, a smart alarm device, a smart electrical meter, and a smart water meter.

According to a third aspect, an embodiment of this application provides an electronic device, including a processor. The processor is coupled to a memory. The memory is configured to store a program or instructions. When the program or the instructions are executed by the processor, the electronic device is enabled to perform the method according to any one of the first aspect.

According to a fourth aspect, an embodiment of this application provides a computer program product. The computer program product includes computer program code. When the computer program code is executed by a computer, the computer is enabled to implement the method according to any one of the first aspect.

According to a fifth aspect, an embodiment of this application provides a computer-readable storage medium, configured to store a computer program or instructions. When the computer program or the instructions are executed, a computer is enabled to perform the method according to any one of the first aspect.

According to a sixth aspect, an embodiment of this application provides a chip. The chip includes a processor and a communication interface. The communication interface is, for example, an input/output interface, a pin, or a circuit. The processor is configured to read instructions to perform the method according to any one of the first aspect.

**BRIEF DESCRIPTION OF DRAWINGS**

FIG. 1 is a schematic diagram of a scenario of configuring device information of a home device in a conventional method;
FIG. 2 is a schematic diagram of a scenario of a communication system according to an embodiment of this application;
FIG. 3A is a schematic diagram of a scenario of a principle of a two-way ranging technology;
FIG. 3B is a schematic diagram of a scenario of a principle of UWB locating;
FIG. 4 is a schematic diagram of a scenario of symmetric layouts according to an embodiment of this application;
FIG. 5 is a schematic flowchart of steps of an embodiment of a method for configuring a home device according to an embodiment of this application;
FIG. 6 is a schematic diagram of a scenario in which an installation and maintenance device communicates with home devices through PLC according to an embodiment of this application;
FIG. 7A is a schematic diagram of an example of a first three-dimensional model according to an embodiment of this application;
FIG. 7B is a schematic diagram of an example of performing matching on a first three-dimensional model and a second three-dimensional model according to an embodiment of this application;
FIG. 7C is a schematic diagram of another example of performing matching on a first three-dimensional model and a second three-dimensional model according to an embodiment of this application;
FIG. 8 is a schematic diagram of a scenario of an example of prompt information according to an embodiment of this application;
FIG. 9 is a schematic diagram of a scenario of an example of a matching result including a location node that fails to be matched according to an embodiment of this application;
FIG. 10 is a schematic diagram of a scenario of another example of a matching result according to an embodiment of this application;
FIG. 11 is a schematic diagram of a structure of an embodiment of an installation and maintenance device according to an embodiment of this application; and
FIG. 12 is a schematic diagram of a structure of a first embodiment of an electronic device according to an embodiment of this application.

**DESCRIPTION OF EMBODIMENTS**

The following describes the technical solutions in embodiments of this application with reference to the accompanying drawings in embodiments of this application. In the specification, the claims, and the accompanying drawings of this application, the terms "first", "second", and the like are intended to distinguish between similar objects but do not necessarily indicate a specific order or sequence. It should be understood that the terms used in such a way are interchangeable in proper circumstances so that embodiments described herein can be implemented in orders other than the order illustrated or described herein.

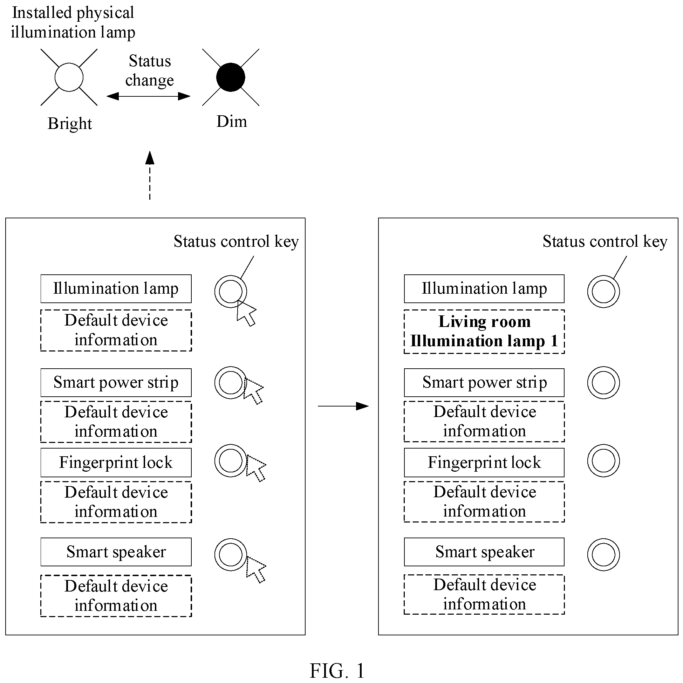

In an early stage of fit-out, a fit-out worker installs home devices to specified installation locations. After the home devices are installed, the fit-out worker needs to set device information for each home device. The device information is used to differentiate the different home devices. For example, the device information may include a room name and a home device name. In a current method, a process in which a fit-out worker sets device information is as follows. As shown in FIG. 1, an installation and maintenance device is communicatively connected to home devices. The installation and maintenance device displays various home device icons, and each icon corresponds to a status control key. When the fit-out worker clicks the status control key corresponding to the home device (for example, an illumination lamp), the status control key is configured to control a status change of the home device. The fit-out worker can determine a currently controlled home device through a status change (for example, turn-on/turn-off) of the home device. Then, the fit-out worker can manually configure device information of the currently controlled home device. For example, if the fit-out worker determines that the currently controlled home device is an illumination lamp in a living room, the installation and maintenance device receives device information of the illumination lamp that is input by the fit-out worker. For example, the device information is: Living room (room name), Illumination lamp 1 (home device name). According to this method, the fit-out worker clicks the status control key corresponding to each home device icon one by one, and sets device information of currently controlled home devices after determining the currently controlled home devices. Usually, there are a large quantity (up to hundreds) of home devices in one house, let alone dozens or even hundreds of houses that the fit-out worker needs to fit out. The fit-out worker sets each home device in each house one by one according to this method. This results in low efficiency of installation and maintenance and a heavy workload of the fit-out worker.

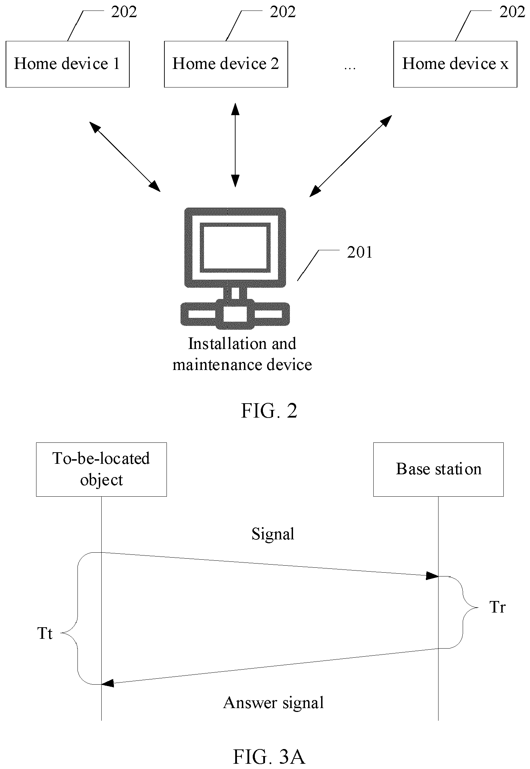

An embodiment of this application provides a method for configuring device information of a home device. The method may be applied to a communication system. As shown in FIG. 2, the communication system includes an installation and maintenance device 201 and a plurality of home devices 202, and each home device 202 is communicatively connected to the installation and maintenance device 201. The home device includes but is not limited to internet of things (internet of things, IoT) devices such as a smart power strip, an electronic door lock, a smart speaker, an illumination device, a smart home appliance, a curtain control device, a home gateway, a projection device, a home robot, a sensing device, a gas control device, a smart alarm device, a smart electrical meter, and the like. The installation and maintenance device may be a personal computer (personal computer, PC), a mobile phone, a tablet computer, or the like, or may be a terminal device dedicated to installation and maintenance. In this embodiment of this application, an example in which the installation and maintenance device is a PC is used for description. When the fit-out worker fit outs a $1^{st}$ house, device information of home devices in the first house may be configured according to a conventional method. After the device information of the $1^{st}$ house is configured, the installation and maintenance device may obtain location information of each home device in the first house. The installation and maintenance device can generate a three-dimensional model (referred to as a "first three-dimensional model") based on the location information of the home device in the $1^{st}$ house. The first three-dimensional model is a three-dimensional model used to describe a location of each home device in the $1^{st}$ house. Then, when another house is fit out, the first three-dimensional model is used as a template model of locations of home devices based on a characteristic that layouts of a plurality of houses are the same or layouts of a plurality of houses are symmetric to each other. The installation and maintenance device obtains a plurality of pieces of location information of a plurality of home devices installed in a $2^{nd}$ house (or another house). Then, the installation and maintenance device generates a second three-dimensional model based on the plurality of pieces of location information of the plurality of home devices in the $2^{nd}$ house. If the first three-dimensional model and the second three-dimensional model are successfully matched, the installation and maintenance device may automatically configure device information of the home devices in the $2^{nd}$ house based on the device information of the home devices in the $1^{st}$ house. The fit-out worker does not need to configure device information of each home device in each house one by one, and device information of home devices in one or more houses can be configured together. This improves efficiency of an installation and maintenance process.

To better describe this application, words in this application are described by using examples.

First, several locating methods are described by using examples.

(1) Ultra-wideband (ultra-wideband, UWB) locating

UWB is a wireless communication technology that transmits data at a high speed in a short distance with extremely low power. Bandwidth can determine a distance resolution capability of a signal in a multi-path environment. The UWB features wide bandwidth and a strong multipath resolution capability, and can distinguish and eliminate impact of most of multipath interference signals. Therefore, a high-precision locating result can be obtained through UWB locating. The UWB locating method described by using examples.

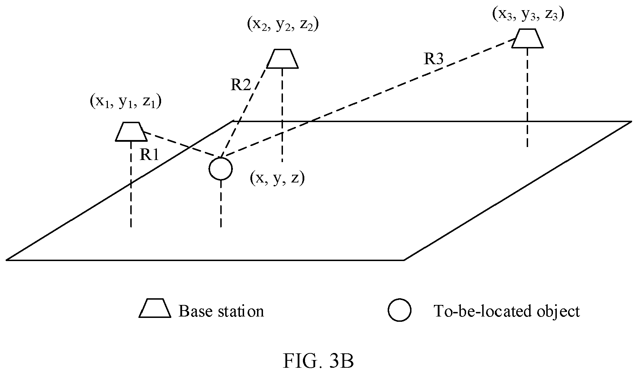

A plurality of base stations are installed in a ranging environment, and the base station is configured to receive and send a signal. The UWB locating technology can use time of flight (time of flight, TOF) ranging, and the TOF ranging method is a two-way ranging technology. To be specific, a distance between nodes is measured by using a time of flight of a signal between the base station and a to-be-located object. Then, the to-be-located object (or a locating apparatus) determines a location of the to-be-located object based on a location of each base station and a distance between the to-be-located object and each base station. For example, as shown in FIG. 3A, a to-be-located object sends a signal to a base station, and after receiving the signal, the base station sends an answer signal to the to-be-located object. An interval between a time point at which the to-be-located object sends the signal and a time point at which the to-be-located object receives the answer signal from the base station is denoted as Tt. An interval between a time point at which the base station receives a pulse signal from the to-be-located object and a time point at which the base station sends the answer signal is denoted as Tr. A one-way time of flight of the signal between the to-be-located object and the base station is Tf = (Tt - Tr)/2. A distance between the to-be-located object and the base station is d = c × Tf. c represents a propagation speed of an electromagnetic wave. As shown in FIG. 3B, three-dimensional locating is implemented through UWB. At least three locating base stations with known coordinates are disposed indoors, and a to-be-located object carries a UWB chip. The to-be-located object transmits pulses at a specific frequency, to measure a distance between the to-be-located object and each base station. Then, the to-be-located object may determine a location of the to-be-located object based on a location of each base station and the distance between the to-be-located object and each base station. For example, the known coordinates of the three base stations are $(x_1, y_1, z_1)$, $(x_2, y_2, z_2)$, and $(x_3, y_3, z_3)$, and distances from the to-be-located object to four base stations are $R_1$, $R_2$, and $R_3$. Coordinates (x, y, z) of the to-be-located object is obtained by solving Formula (1):

$$
\begin{aligned}
(x - x_1)^2 + (y - y_1)^2 + (z - z_1)^2 &= R_1{}^2 \\
(x - x_2)^2 + (y - y_2)^2 + (z - z_2)^2 &= R_2{}^2 \qquad\qquad \text{Formula (1)} \\
(x - x_3)^2 + (y - y_3)^2 + (z - z_3)^2 &= R_3{}^2
\end{aligned}
$$

(2) Ultrasonic locating

Ultrasonic locating mainly uses a reflective ranging method, and determines a location of a to-be-located object by using methods such as multilateral locating and the like. An entire locating system may include a main rangefinder and a plurality of receivers. For example, the main rangefinder is disposed on the to-be-located object, and the plurality of receivers are fixedly disposed at different locations in an indoor environment. During locating, the main rangefinder transmits signals of a same frequency to the receivers. After receiving the signal, the receiver sends a feedback signal to the main rangefinder. The main rangefinder can calculate a distance between the main rangefinder and each receiver based on an interval between a time point at which the main rangefinder sends the signal and a time point at which the main rangefinder receives the feedback signal from the main rangefinder, to determine location coordinates of the to-be-located object. Ultrasonic locating has advantages of strong anti-interference and high precision, and the locating precision can reach a centimeter level.

(3) Wireless fidelity (wireless fidelity, Wi-Fi) locating

A Wi-Fi locating system may include some fixed access points (access points, APs). The APs are deployed at indoor locations that are conducive to installation. The locations of the APs in a house are known. To-be-located objects may directly or indirectly communicate with each other through the AP. In addition, the to-be-located object may be located by using a Wi-Fi location fingerprint algorithm. A "location fingerprint" associates a location in an actual environment with a "fingerprint", and one location corresponds to one unique fingerprint. For example, the "fingerprint" may be a signal characteristic (for example, signal strength). For example, the to-be-located object may receive a signal sent by the AP, and then may estimate a location of the to-be-located object based on signal strength of the signal. A process of estimating the location may be as follows. The to-be-located object performs matching on a sensed signal characteristic and a signal characteristic in a database. In the database, each fingerprint is in a correspondence with each location. The to-be-located object or a locating apparatus determines, based on a fingerprint that is matched, a location corresponding to the fingerprint. Costs of AP deployment in Wi-Fi locating are low.

Then, a "layout" in embodiments of this application is described by using examples.

The layout may be an arrangement and shapes of rooms. For example, a house may include a plurality of rooms, such as a primary bedroom, a secondary bedroom, a living room, a bathroom, a balcony, and the like. That layouts of two houses are the same may mean that an arrangement of rooms in a house A is the same as an arrangement of rooms in a house B and a shape of each room in the house A is the same as a shape of each room in the house B. For example, a shape of a primary bedroom in the house A is the same as a shape of a primary bedroom in the house B, and a shape of a living room in the house A is the same as a shape of a living room in the house B.

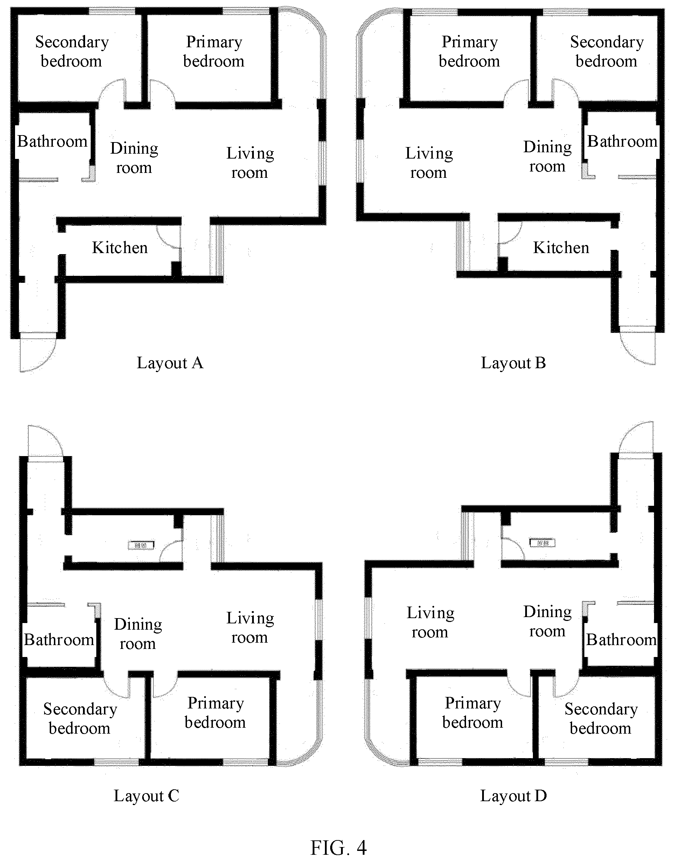

"Symmetric layouts" are described. The "symmetric layouts" may mean that an arrangement of rooms of a house A is axially or centrally symmetric to an arrangement of rooms of a house B and a shape of each room in the house A is the same as a shape of each room in the house B. As shown in FIG. 4, a layout A is axially symmetric to a layout B, the layout A is axially symmetric to a layout C, and the layout A is centrally symmetric to a layout D. In other words, if the layout of the house A is the layout A, a "symmetric layout" of the house A may be the layout B, the layout C, or the layout D.

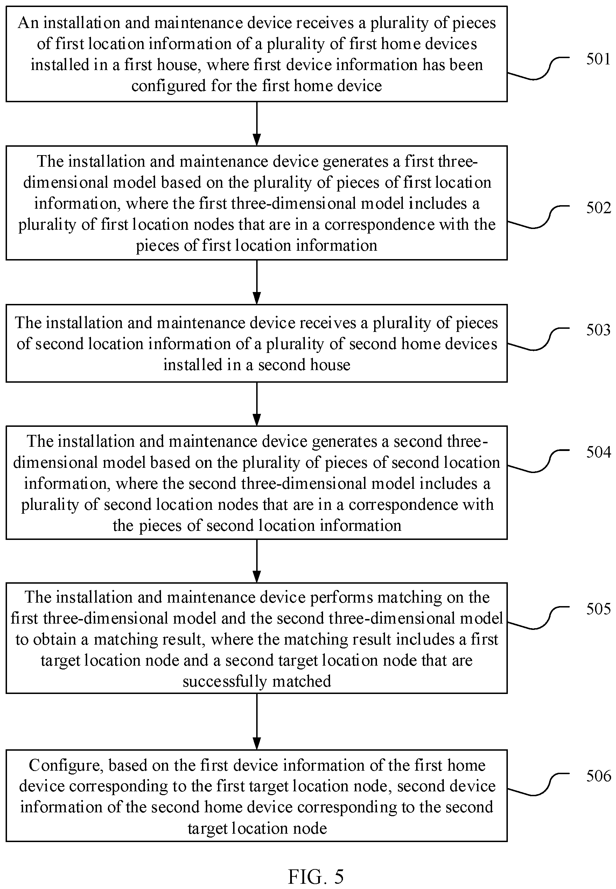

Refer to FIG. 5. The following describes a method for configuring device information of a home device according to an embodiment of this application by using an example. For ease of description, in this embodiment, a house used as a template is referred to as a "first house", and a house to be fit out is referred to as a "second house". A "home device" installed in the first house is referred to as a "first home device", and a "home device" installed in the second house is referred to as a "second home device". Location information of the first home device is referred to as "first location information", and location information of the second home device is referred to as "second location information". A three-dimensional model corresponding to the home device in the first house is referred to as a "first three-dimensional model", and a three-dimensional model corresponding to the home device in the first house is referred to as a "second three-dimensional model".

Step 501: An installation and maintenance device receives a plurality of pieces of first location information of a plurality of first home devices installed in the first house, where first device information has been configured for the first home devices.

The plurality of first home devices are installed in the first house. For example, the first house includes a plurality of rooms such as a primary bedroom, a secondary bedroom, a living room, and the like, and device information has been configured for a home device installed in each room. For example, the device information of the home devices in the first house is shown in Table 1.

Table 1

| Home device | Room | Identifier | Installation location identifier |
|---|---|---|---|
| Smart power strip | Living room | Smart power strip 1 | 110 |
| Smart power strip | Primary bedroom | Smart power strip 2 | 120 |
| Illumination lamp | Living room | Illumination lamp 1 | 130 |
| Illumination lamp | Living room | Illumination lamp 2 | 140 |
| Illumination lamp | Primary bedroom | Illumination lamp 3 | 150 |
| Illumination lamp | Primary bedroom | Illumination lamp 4 | 160 |
| Illumination lamp | Secondary bedroom | Illumination lamp 5 | 170 |
| Illumination lamp | Secondary bedroom | Illumination lamp 6 | 180 |
| ... | ... | ... | ... |

Table 1 merely describes the home devices installed in the first house by using examples, and does not constitute a limitation. In Table 1, an "installation location identifier" is used to describe an installation location of a home device in a house. The location at which the home device needs to be installed in the house is identified. A fit-out worker can install the home device at the specified location based on the installation location identifier. For example, an illumination lamp 1 is installed at a location "110" on a ceiling. "Identifiers" in Table 1 identify or are used to differentiate different home devices. For example, the identifier may be expressed by using a sequence number and a home device name. For example, in an implementation, each identifier in the foregoing "identifier" column uniquely identifies one home device within the house. Refer to examples in the "identifier" column in Table 1. In another implementation, the "room" and the "identifier" may uniquely identify one home device. For example, refer to examples in Table 2.

Table 2

| Home device | Room | Identifier | Installation location identifier |
|---|---|---|---|
| Smart power strip | Living room | Smart power strip 1 | 100 |
| Smart power strip | Primary bedroom | Smart power strip 1 | 100 |
| Illumination lamp | Living room | Illumination lamp 1 | 110 |
| Illumination lamp | Living room | Illumination lamp 2 | 120 |
| Illumination lamp | Primary bedroom | Illumination lamp 1 | 110 |
| Illumination lamp | Primary bedroom | Illumination lamp 2 | 120 |
| Illumination lamp | Secondary bedroom | Illumination lamp 1 | 110 |
| Illumination lamp | Secondary bedroom | Illumination lamp 2 | 120 |
| ... | ... | ... | ... |

For example, as shown in Table 2, an "identifier" uniquely identifies one home device within a room. Similarly, an installation location identifier may uniquely identify an installation location of one home device within a house (as shown in Table 1), or may uniquely identify an installation location of one home device within a room (as shown in Table 2).

There are at least the following two implementations in which the installation and maintenance device obtains the plurality of pieces of first location information of the plurality of first home devices installed in the first house.

In a first implementation, the installation and maintenance device receives the location information from the home device. Correspondingly, the home device sends the location information to the installation and maintenance device. In this implementation, the home device has a locating function, and a locating method of the home device includes but is not limited to several indoor locating methods such as UWB, ultrasonic, Wi-Fi, Bluetooth, radio frequency identification (radio frequency identification, RFID), ZigBee, and the like, or may be a combination of the foregoing several locating methods. Each first home device sends the first location information to the installation and maintenance device.

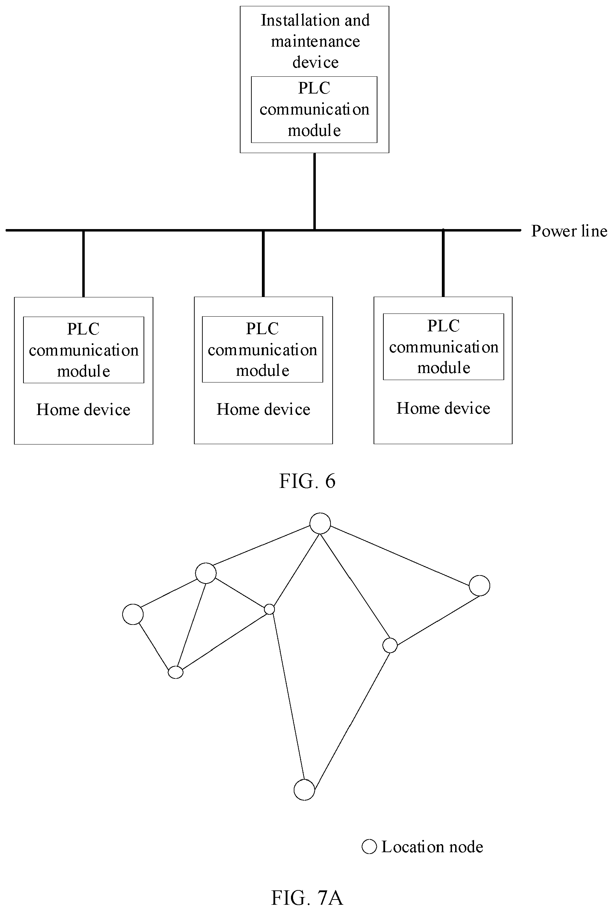

Optionally, each home device may communicate with the installation and maintenance device by using a power line communication (power line communication, PLC) technology. PLC is a communication mode in which data is transmitted through a power line. PLC means that an original signal is modulated into a high-frequency signal, then the high-frequency signal is loaded onto the power line for transmission, and at a receiving end, the modulated signal is extracted through a filter and demodulated to obtain the original signal and therefore implement information transmission. As shown in FIG. 6, the home devices and the installation and maintenance device each may have a built-in PLC communication module, and each home device sends first location information to the installation and maintenance device through a power line. The PLC communication mode does not need an additional communication medium. The home device and the installation and maintenance device can be communicatively connected wherever the power line passes. This reduces costs of network deployment.

In a second implementation, the installation and maintenance device receives the location information from a locating apparatus. The locating apparatus may be an electronic device having a locating function, such as a mobile phone, a barcode scanner, or the like. For example, a marking of the home device (for example, a quick response code including a MAC address of the home device) is attached to a surface of the home device. The locating apparatus has a scanning function. The locating apparatus scans the quick response code to obtain the MAC address of the home device. The locating apparatus sends the MAC address of the home device and location information to the installation and maintenance device. The installation and maintenance device identifies the home device based on the MAC address, and uses the location information of the locating apparatus as the location information of the home device. A locating method of the locating apparatus includes but is not limited to UWB, ultrasonic, Wi-Fi, Bluetooth, RFID, ZigBee, and the like, or may be a combination of the foregoing several locating methods.

Step 502: The installation and maintenance device generates a first three-dimensional model based on the plurality of pieces of first location information, where the first three-dimensional model includes a plurality of first location nodes that are in a correspondence with the pieces of first location information.

As shown in FIG. 7A, the installation and maintenance device generates the first three-dimensional model based on the plurality of pieces of first location information, where the first three-dimensional model is a location model of spatial locations of the plurality of first home devices, and the first three-dimensional model may be used as a template model of locations of home devices. The first location information of each first home device is mapped to a first location node in the first three-dimensional model. It may be understood that the first location node may represent the corresponding first home device. The first three-dimensional model may be a scatter model. Alternatively, the first three-dimensional model may be an irregular three-dimensional model. For example, a location node is connected to another location node within a preset range, to obtain an irregular three-dimensional model. Another location node within a preset range of a location node F may be a location node within a range of a sphere centered at the location node F with a radius r, where r may be set based on an actual requirement.

It should be noted that step 501 and step 502 are steps of obtaining the first three-dimensional model. After obtaining the first three-dimensional model, the installation and maintenance device may store the first three-dimensional model. There is no need to perform step 501 and step 502 each time when another house whose layout is the same as or symmetric to a layout of the first house is fit out. Step 501 and step 502 are optional steps.

Step 503: The installation and maintenance device receives a plurality of pieces of second location information of a plurality of second home devices installed in the second house.

The second house may be any house whose layout is the same as or symmetric to the layout of the first house. After the plurality of second home devices are installed in the second house, the installation and maintenance device obtains the plurality of pieces of second location information of the plurality of second home devices. There are two manners in which the installation and maintenance device obtains the second location information. For the two manners, refer to descriptions of the first implementation and the second implementation of step 501. Details are not described herein.

Step 504: The installation and maintenance device generates a second three-dimensional model based on the plurality of pieces of second location information, where the second three-dimensional model includes a plurality of second location nodes that are in a correspondence with the pieces of second location information.

The installation and maintenance device generates the second three-dimensional model based on the plurality of pieces of second location information. The second location information of each second home device is mapped to a second location node in the second three-dimensional model. The second three-dimensional model may be a scatter model. Alternatively, the second three-dimensional model may be an irregular three-dimensional model.

Step 505: The installation and maintenance device performs matching on the first three-dimensional model and the second three-dimensional model to obtain a matching result, where the matching result includes a first target location node and a second target location node that are successfully matched.

When a layout of the second house is the same as the layout of the first house, the installation and maintenance device directly performs matching on the first three-dimensional model and the second three-dimensional model. When a layout of the second house is symmetric to the layout of the first house, the installation and maintenance device may first perform symmetry transformation on a second three-dimensional model A to obtain a transformed second three-dimensional model B, and then perform matching on the first three-dimensional model and the second three-dimensional model B; or the installation and maintenance device may first perform symmetry transformation on a first three-dimensional model A to obtain a transformed first three-dimensional model B, and then perform matching on the first three-dimensional model B and the second three-dimensional model. In this embodiment, an example in which the layout of the second house is the same as the layout of the first house is used for description.

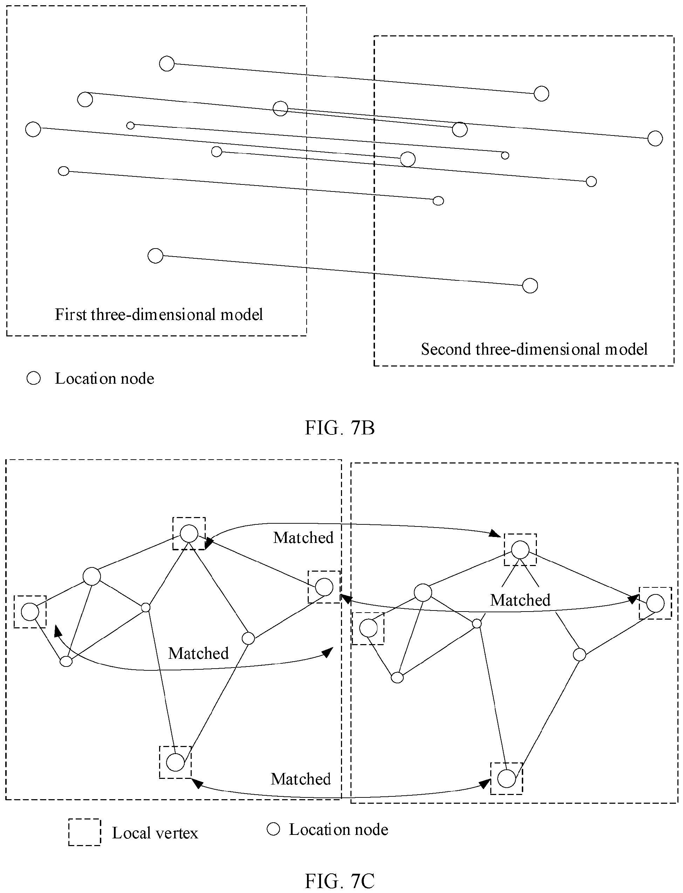

For example, as shown in FIG. 7B, when the first three-dimensional model and the second three-dimensional model are scatter models, a method for performing matching on the two three-dimensional models by the installation and maintenance device may be as follows: Brute force (brute force) matching is performed on the plurality of first location nodes and the plurality of second location nodes. If a Euclidean distance between the first target location node in the plurality of first location nodes and the second target location node in the plurality of second location nodes is less than or equal to a first threshold, the first target location node and the second target location node are matched.

For example, as shown in FIG. 7C, when the first three-dimensional model and the second three-dimensional model are irregular three-dimensional models, a method for performing matching on the two three-dimensional models by the installation and maintenance device may be as follows. First, the installation and maintenance device performs matching on a shape of the first three-dimensional model and a shape of the second three-dimensional model. For example, the installation and maintenance device determines a plurality of first local vertices of the first three-dimensional model and a plurality of second local vertices of the second three-dimensional model. Brute force matching is performed on the plurality of first local vertices of the first three-dimensional model and the plurality of second local vertices of the second three-dimensional model. The plurality of first local vertices of the first three-dimensional model and the second local vertices of the second three-dimensional model are matched. Alternatively, a ratio of a quantity (for example, denoted as "n") of location nodes that are matched in the plurality of first local vertices and the plurality of second local vertices to a quantity of first local nodes (or a quantity of second local nodes, for example, denoted as "m") is greater than or equal to a second threshold. In other words, a ratio of n to m is greater than or equal to the second threshold. In this case, the installation and maintenance device determines that the shape of the first three-dimensional model and the shape of the second three-dimensional model are matched. For example, the first local vertex is a location node at an edge of the first three-dimensional model, and the second local vertex is a location node at an edge of the second three-dimensional model; or the first local vertex is a location node on an envelope plane of a smallest envelope cube of the first three-dimensional model, and the second local vertex is a location node on an envelope plane of a smallest envelope cube of the second three-dimensional model.

Then, the first three-dimensional model and the second three-dimensional model are overlapped based on the first local vertex and second local vertex that are matched. The first three-dimensional model includes a plurality of location nodes, and there is a connection relationship between a location node and another location node within a preset range of the location node. The connection relationship may be represented by a line connecting two location nodes (as shown in FIG. 7C), and the connection relationship is used to establish a constraint on relative locations of the two location nodes that are connected. The installation and maintenance device determines an overlapping location of location nodes in the first three-dimensional model and the second three-dimensional model, and the installation and maintenance device determines a Euclidean distance between a first location node and a second location node that are at the overlapping location. When the installation and maintenance device determines that the Euclidean distance between the first location node and the second location node that are at the overlapping location is less than or equal to the second threshold, the installation and maintenance device determines that the first location node and the second location node that are at the overlapping location are matched.

Optionally, to improve accuracy of matching of the first location node and the second location node, the installation and maintenance device may further determine a connection relationship (represented by a vector "a") between the first location node and a first location node within a preset range of the first location node, and a connection relationship (represented by a vector "b") between the second location node and a second location node within a preset range of the second location node. For example, a vector from a first location node A to a first location node B is a1, and a vector from a second location node A to a second location node B is b 1. A dot product operation is performed on the two vectors, as shown in Formula (2):

$$a \cdot b = |a||b|\cos\theta;$$

and

$$\theta = \arccos(\frac{a \cdot b}{|a||b|}) \quad \text{Formula (2)},$$

where a and b represent the vectors, |*| represents a modulus of the vector, and $\theta$ represents an included angle between the vector a and the vector b.

When the installation and maintenance device determines that the Euclidean distance between the first location node and the second location node that are at the overlapping location is less than or equal to the second threshold, and the included angle between the vector a and the vector b is less than or equal to a third threshold, the installation and maintenance device determines that the first location node and the second location node that are at the overlapping location are matched. For ease of description, the first location node and the second location node that are matched are referred to as the "first target location node" and the "second target location node".

Step 506: The installation and maintenance device configures, based on the first device information of the first home device corresponding to the first target location node, second device information of the second home device corresponding to the second target location node.

For example, a first target location node A corresponds to a first home device A, a second target location node A corresponds to a second home device A, and the first target location node A and the second target location node A are matched. It indicates that a location (for example, an installation location identifier is 110) at which the first home device A is installed in the first house is the same as a location (for example, an installation location identifier is 110) at which the second home device A is installed in the second house. The installation and maintenance device configures second device information of the second home device A as first device information of the first home device A. For example, the first device information of the first home device A is: Living room (room), Illumination lamp 1 (home device name), 110 (installation location identifier). In this case, the installation and maintenance device configures the second device information of the second home device A as: Living room (room), Illumination lamp 1 (name), 110 (installation location identifier).

For better understanding of this application, a scenario is used as an example. When fitting out a 1st house, the fit-out worker installs, at fixed locations, all home devices in the 1st house based on installation location identifiers. Then, the fit-out worker first configures device information of all the home devices in the 1st house according to a conventional method. For example, the device information may be shown in Table 1. All the home devices in the 1st house have a locating function. Each home device in the 1st house sends location information of the home device to the installation and maintenance device, and the installation and maintenance device generates a first three-dimensional model based on a plurality of received location information. The 1st house may be used as a template for fitting out another house. After the fit-out worker installs home devices in another house (whose layout is the same as or symmetric to a layout of the 1st house), each home device in the another house also sends location information of the home device to the installation and maintenance device, and the installation and maintenance device generates a three-dimensional model based on location information of the home devices in each house. For example, the installation and maintenance device generates a three-dimensional model B based on location information sent by all home devices in a 2nd house, a three-dimensional model C based on location information sent by all home devices in a 3rd house, and so on. The three-dimensional model B is used as an example. The installation and maintenance device performs matching on the three-dimensional model B and a three-dimensional model A. If all location nodes in the three-dimensional model A and all location nodes in the three-dimensional model B are matched, the installation and maintenance device automatically configures (or fills in) second device information of a second home device in the 2nd house based on first device information of a first home device in the 1st house. For example, device information of a home device installed at a location identified by an installation location identifier 110 in the 1st house is: Living room (room), Illumination lamp 1 (name), 110 (installation location identifier); and device information of a home device installed at a location identified by an installation location identifier 110 in the 2nd house is also configured as: Living room (room), Illumination lamp 1 (name), 110 (installation location identifier).

For example, after device information of home devices in each house is configured, a control device may identify each home device based on the device information of the home device, to control a plurality of home devices to collaborate with each other. A scenario in which the plurality of home devices collaborate with each other may include the following several modes, for example, a guest reception mode, a movie watching mode, an away mode, a sleep mode, a karaoke mode, a kids mode, a focus mode, a home mode, a work mode, and an elderly care mode. When or after a home device collaboration scenario is configured for the first house, the installation and maintenance device configures a second home device collaboration scenario for the second house based on a first home device collaboration scenario, where the second home device collaboration scenario is the same as or similar to the first home device collaboration scenario.

The foregoing several modes are described by using examples.

In the guest reception mode, the control device controls an illumination lamp 1, an illumination lamp 2, and an illumination lamp 3 in a living room to be in an on state, and illumination statuses of the illumination lamp 1, the illumination lamp 2, and the illumination lamp 3 to be "Bright".

In the away mode, the control device controls all illumination lamps in the house to be in an off state, and a fingerprint lock, an infrared human body sensor, and a smoke alarm in the living room to work.

In the movie watching mode, the control device controls the illumination lamp 1, the illumination lamp 3, and an illumination lamp 5 in the living room to be turned on and dimmed, and a speaker in the living room to be turned on.

In the sleep mode, the control device controls all lamps in the house to be turned off, a night light to be turned on, and an indoor security device to be started.

In the karaoke mode, the control device controls a curtain to be closed, the illumination lamps in the living room to be dimmed, a television and the speaker in the living room to be turned on, and the speaker to be in a reverberation mode.

In the home mode, the control device controls the lamps in the living room to be turned on, and an air conditioner to start to work.

In the focus mode, the control device controls the television and the speaker to be turned off, and controls a mobile phone to be in a do not disturb mode.

In the kids mode, the control device controls the television to be turned on, switch to a kids channel, and play a program appropriate for a kid to watch; or the control device may start a smart speaker, so that a kid can talk to the smart speaker; or the control device may adjust an air conditioner in a kids' room to a temperature, where the temperature is a temperature appropriate for a kid.

In the work mode, the control device controls an air conditioner in a study to be turned on, and a computer to automatically turn on.

In the elderly care mode, the control device detects consumptions of gas, water, and electricity through a gas control device, a smart electrical meter, and a smart water meter. When the consumptions of gas, water, and electricity each are less than a preset value in a preset time period (for example, one day), and the electronic door lock has not been opened, the control device controls a smart alarm device to raise an alarm.

In this embodiment of this application, the device information has been configured for all the first home devices in the 1st house. The installation and maintenance device generates the first three-dimensional model based on a plurality of pieces of location information of the plurality of first home devices. The first three-dimensional model may be used as a template model of spatial locations of all the home devices in the first house. When the second house is fit out, the installation and maintenance device obtains the plurality of pieces of second location information of the plurality of second home devices installed in the second house. Similarly, the installation and maintenance device generates the second three-dimensional model based on the plurality of pieces of second location information. Then, the installation and maintenance device performs matching on the first three-dimensional model and the second three-dimensional model to obtain the matching result, where the matching result includes the first target location node and the second target location node that are successfully matched. Finally, the installation and maintenance device automatically configures, based on the first device information of the first home device corresponding to the first target location node, the second device information of the second home device corresponding to the second target location node. The installation and maintenance device can configure device information of home devices in a plurality of houses in bulk. The fit-out worker does not need to configure device information of each home device in each house one by one. This improves efficiency of an installation and maintenance process.

Optionally, because the first three-dimensional model is a template model of spatial locations of home devices, the installation and maintenance device successfully obtains the pieces of first location information of all the first home devices in the first house, to ensure accuracy of the first three-dimensional model. In this embodiment, the first three-dimensional model is visualized, to help the fit-out worker verify the first location node in the first three-dimensional model. The method may further include step S20.

S20: The installation and maintenance device displays the first three-dimensional model and a first installation location identifier of each first location node in the first three-dimensional model, where the first installation location identifier is used to describe an installation location of a home device.

For example, each installation location identifier may uniquely identify an installation location of one home device in the 1st house. The fit-out worker checks each installation location identifier on a fit-out plan and an installation location identifier of each first location node in the first three-dimensional model. If the installation location identifiers of all the first location nodes in the first three-dimensional model are consistent with installation location identifiers of all home devices on the fit-out plan, it indicates that the first three-dimensional model can describe spatial locations of all the home devices in the first house. If an installation location identifier (for example, "210") of one home device (or installation location identifiers of a plurality of home devices) on the fit-out plan is not displayed on the installation and maintenance device, it indicates that the home device may fail to report location information, and consequently the first three-dimensional model includes a location node corresponding to the home device. The fit-out worker needs to find a cause, to ensure correctness of the first three-dimensional model.

Optionally, to enable the fit-out worker to learn of whether device information of the second home device in the second house is successfully configured, and to perform a targeted check when the device information of the second home device fails to be configured, step S30 may be further included.

S30: When the matching result indicates that there is a location node that fails to be matched, the installation and maintenance device generates first prompt information, where the first prompt information includes an identifier of the second house. When the matching result indicates that all first location nodes in the first three-dimensional model and all second location nodes in the second three-dimensional model, the installation and maintenance device generates second prompt information.

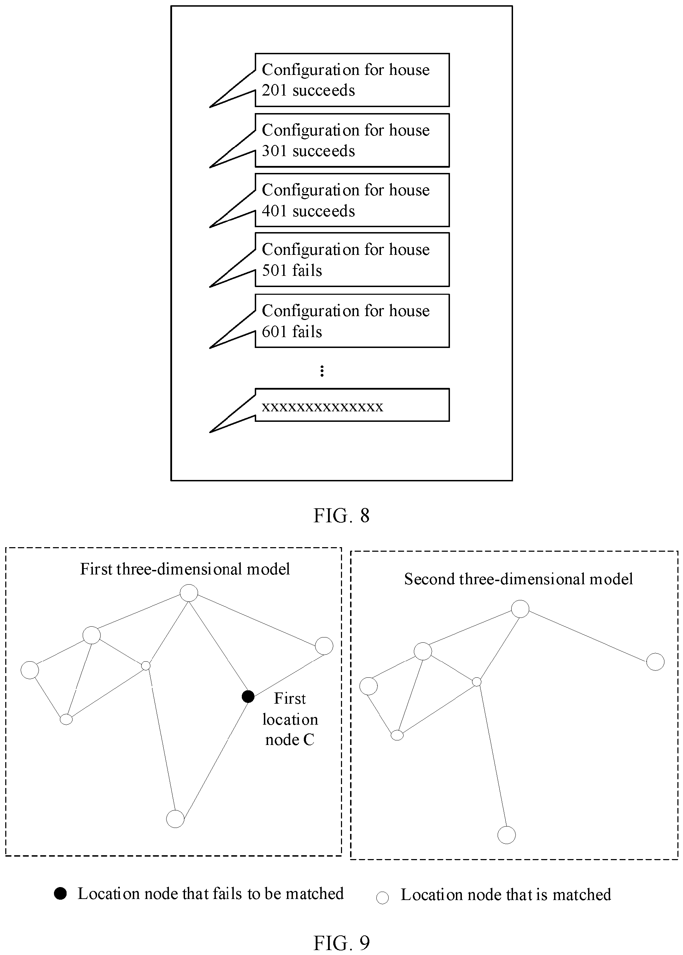

It may be understood that, in a scenario, the fit-out worker needs to fit out houses in an entire building. A 1st house fit out by the fit-out worker may be used as a template house. To be specific, the 1st house fit out by the fit-out worker is a first house, and any other house in the entire building may be a second house, for example, a second house A (for example, house 201), a second house B (for example, house 301), or a second house C (for example, house 401). To improve efficiency of fit-out, matching is performed on a second three-dimensional model of the house 201 and a first three-dimensional model of the first house, matching is performed on a second three-dimensional model of the house 301 and the first three-dimensional model of the first house, and matching is performed on a second three-dimensional model of the house 401 and the first three-dimensional model of the first house. To be specific, matching is performed on the first three-dimensional model of the first house and second three-dimensional models of a plurality of second houses together. Therefore, if a matching result indicates that there is a location node that fails to be matched, the installation and maintenance device generates first prompt information, where the first prompt information is used to notify the fit-out worker that there is a second home device, in the second house, for which device information fails to be configured, and the first prompt information includes a house identifier. For example, the house identifier may be a house number. For example, the first prompt information is "Configuration for house 201 fails", or the first prompt information is "Matching for house 201 fails". The fit-out worker may perform a targeted check on a second home device in the house 201. For example, the installation and maintenance device fails to receive second location information from the second home device in the house 201, and consequently there is a location node that fails to be matched. As shown in FIG. 8, the installation and maintenance device displays a list. The list includes first prompt information and second prompt information, for example, "Configuration for house 201 succeeds", "Configuration for house 301 succeeds", "Configuration for house 401 succeeds", and "Configuration for house 501 fails". Alternatively, the list displays only first prompt information. For example, the list includes "Configuration for house 501 fails" and "Configuration for house 601 fails".

Optionally, in order not to miss configuring the second device information of the second home device in the second house, the installation and maintenance device visualizes the first three-dimensional model, the second three-dimensional model, and the matching result, so that the fit-out worker checks the location node that fails to be matched, to ensure that second device information of all the second home devices in the second house is successfully configured. The method further includes step S40.

S40: The installation and maintenance device displays the first three-dimensional model, the second three-dimensional model, and the matching result, where the matching result further includes the location node that fails to be matched.

As shown in FIG. 9, the installation and maintenance device may differentiate, by displaying different identifiers, a location node that is successfully matched and a location node that fails to be matched. For example, the installation and maintenance device may differentiate the location node that is successfully matched by using "points" in different colors. For example, a white point identifies the location node that is successfully matched, and a black point identifies the location node that fails to be matched. Alternatively, the installation and maintenance device may differentiate, by using points of different shapes, the location node that is successfully matched and the location node that fails to be matched. For example, an elliptical point identifies the location node that is successfully matched, and a triangular point identifies the location node that fails to be matched. The first three-dimensional model of the first house may be a three-dimensional model verified by the fit-out worker. To be specific, all the first home devices in the first house can correspond to the plurality of first location nodes in the first three-dimensional model. In this case, that the matching result includes the location node that fails to be matched may mean that the installation and maintenance device does not successfully obtain, through matching, a second location node that is in the second three-dimensional model and that corresponds to a first location node C in the first three-dimensional model. The installation and maintenance device may display, on the first three-dimensional model, the first location node C that fails to be matched.

For example, the first three-dimensional model includes the first location node C. The installation and maintenance device performs matching on the first three-dimensional model and the second three-dimensional model, and the installation and maintenance device determines that there is no second location node, in the second three-dimensional model, that is matched with the first location node C. In other words, the installation and maintenance device may not successfully obtain location information of a second home device. The installation and maintenance device may display device information C1 corresponding to the first location node C, so that the fit-out worker can search for, based on the device information C1 of the first location node C, the second home device that fails to send the location information. For example, the device information C1 corresponding to the first location node is: Living room (room), Downlight 3 (name), 110 (installation location identifier).

For example, a first operation may be a confirmation operation performed on the first prompt information. First, the installation and maintenance device responds to the confirmation operation performed by the fit-out worker on the first prompt information. Then, the installation and maintenance device displays the first three-dimensional model, the second three-dimensional model, and the matching result based on the confirmation operation.

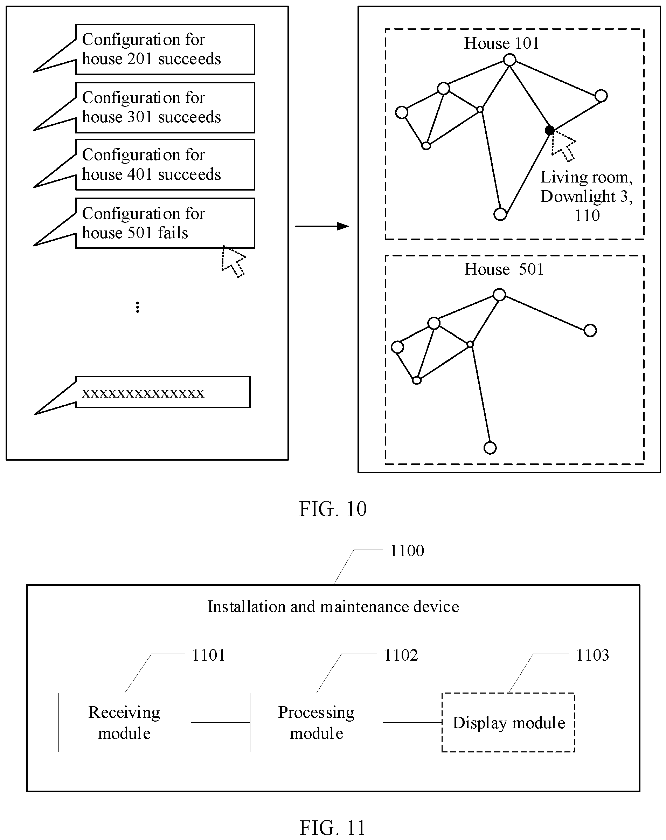

As shown in FIG. 10, in an application scenario, the installation and maintenance device displays a list. The list includes first prompt information and second prompt information, for example, "Configuration for house 201 succeeds", "Configuration for house 301 succeeds", "Configuration for house 401 succeeds", and "Configuration for house 501 fails". In this case, the fit-out worker needs to check second home devices, in the house 501, for which second device information fail to be configured. The fit-out worker may click the prompt information "Configuration for house 501 fails" with a mouse. The installation and maintenance device responds to a confirmation operation performed by the fit-out worker on the first prompt information, and displays a first three-dimensional model of a first house, a second three-dimensional model of the house 501, and a matching result based on the confirmation operation. For example, a first location node D in the first house fails to be matched, and device information of the first location node D is: Living room, Downlight 3, 110. The fit-out worker may check a second home device D installed at an installation location "110" in a living room of the second house, check whether the second home device D is faulty, and scan a quick response code of the second home device D by using a locating apparatus (for example, a mobile phone). The locating apparatus sends the second home device D to the installation and maintenance device. Alternatively, the fit-out worker manually set device information of the second home device D.

Optionally, to enable the fit-out worker to more intuitively observe a location of the second home device in the second house, the installation and maintenance device may display a three-dimensional model (also referred to as a "first house model") of the first house and a three-dimensional model (also referred to as a "second house model") of the second house. The three-dimensional model of the first house includes the first three-dimensional model, and the three-dimensional model of the second house includes the second three-dimensional model.

For example, the installation and maintenance device pre-generates the three-dimensional model of the first house by using three-dimensional software. For example, the three-dimensional software may be 3Dmax, SolidWorks, or the like. When the layout of the first house is the same as the layout of the second house, the installation and maintenance device copies the three-dimensional model of the first house, and uses the copy of the three-dimensional model of the first house as the three-dimensional model of the second house. When the layout of the first house is symmetric to the layout of the second house, the installation and maintenance device pre-generates the three-dimensional model of the second house by using the three-dimensional software.

Optionally, the installation and maintenance device may also respond to a first rotation operation performed by the fit-out worker on the first house model, and display the three-dimensional model of the first house at different viewing angles based on the first rotation operation. Similarly, the installation and maintenance device may respond to a second rotation operation performed by the fit-out worker on the three-dimensional model of the second house, and display the three-dimensional model of the second house from different angles of view. For example, the rotation operation may be: clicking the three-dimensional model, and sliding a cursor on a screen for a specific distance to reach a second contact point. The installation and maintenance device determines the three-dimensional model of the house and a rotation direction of the three-dimensional model based on a direction from a first contact point to the second contact point, and determines a rotation angle of the three-dimensional model of the house based on the distance from the first contact point to the second contact point.

Refer to FIG. 11. An embodiment of this application provides an installation and maintenance device. The installation and maintenance device is configured to perform the method performed by the installation and maintenance device in the foregoing method embodiments. An installation and maintenance device 1100 includes a receiving module 1101 and a processing module 1102. Optionally, the installation and maintenance device may further include a display module 1103.

The receiving module 1101 is configured to receive a plurality of pieces of second location information of a plurality of second home devices installed in a second house.

The processing module 1102 is configured to generate a second three-dimensional model based on the plurality of pieces of second location information. The second three-dimensional model includes a plurality of second location nodes that are in a correspondence with the pieces of second location information.

The processing module 1102 is further configured to perform matching on a first three-dimensional model and the second three-dimensional model to obtain a matching result. The matching result includes a first target location node and a second target location node that are successfully matched. The first three-dimensional model is generated based on a plurality of pieces of first location information of a plurality of first home devices in a first house. First device information has been configured for the first home device. The first three-dimensional model includes a plurality of first location nodes that are in a correspondence with the pieces of first location information. A layout of the second house is the same as a layout of the first house, or a layout of the second house is symmetric to a layout of the first house.

The processing module 1102 is further used to configure, based on the first device information of the first home device corresponding to the first target location node, second device information of the second home device corresponding to the second target location node.

Optionally, the receiving module 1101 is a communication interface. Optionally, the communication interface is an input/output interface or a transceiver circuit. The input/output interface includes an input interface and an output interface. The transceiver circuit includes an input interface circuit and an output interface circuit.

Optionally, the processing module 1102 is a processor. The processor is a general-purpose processor, a dedicated processor, or the like. Optionally, the processor includes a transceiver unit configured to implement receiving and transmitting functions. For example, the transceiver unit is a transceiver circuit, an interface, or an interface circuit. A transceiver circuit, an interface, or an interface circuit that is configured to implement the receiving and transmitting functions is separately deployed, or is integrated and deployed together. The transceiver circuit, the interface, or the interface circuit is configured to read or write code or data. Alternatively, the transceiver circuit, the interface, or the interface circuit is configured to transmit or transfer a signal.

In a possible design, a function of the processing module 1102 is implemented by a processing apparatus, and some or all functions of the processing apparatus are implemented by using software, hardware, or a combination thereof. Therefore, it may be understood that each of the foregoing modules may be implemented by software, hardware, or a combination thereof. In this case, the processing apparatus includes a memory and a processor. The memory is configured to store a computer program, and the processor reads and executes the computer program stored in the memory, to perform corresponding processing and/or steps in the foregoing method embodiments.

Alternatively, the processing apparatus includes only a processor. A memory configured to store a computer program is located outside the processing apparatus, and the processor is connected to the memory through a circuit/wire, to read and execute the computer program stored in the memory. Optionally, some or all functions of the processing apparatus may be implemented by using the hardware. In this case, the processing apparatus includes an input interface circuit, a logic circuit, and an output interface circuit. Optionally, the processing apparatus may be one or more chips, or one or more integrated circuits.

Further, the receiving module 1101 is configured to perform step 501 and step 503 in the embodiment corresponding to FIG. 5. The processing module 1102 is configured to perform step 502, step 504, step 505, and step 506 in the embodiment corresponding to FIG. 5, and S30 in the foregoing method embodiment. The display module 1103 is configured to perform step S20 and step S40 in the foregoing method embodiment.

In an optional implementation, the processing module 1102 is further specifically configured to: copy the first device information of the first home device corresponding to the first target location node, to obtain first device information backup, and use the first device information backup as the second device information of the second home device corresponding to the second target location node.

In an optional implementation, the receiving module 1101 is further configured to receive the plurality of pieces of first location information of the plurality of first home devices installed in the first house.

The processing module 1102 is further configured to generate the first three-dimensional model based on the plurality of pieces of first location information.

In an optional implementation, the first device information includes a first installation location identifier. The first installation location identifier is used to describe an installation location of the first home device. The installation and maintenance device further includes the display module 1103.

The display module 1103 is configured to display the first three-dimensional model and a first installation location identifier corresponding to each first location node in the first three-dimensional model.

In an optional implementation, there are a plurality of second three-dimensional models. Each second three-dimensional model corresponds to a second house. When the matching result further includes a location node that fails to be matched, the processing module 1102 is further configured to generate prompt information. The prompt information includes an identifier of the second house.

In an optional implementation, the processing module 1102 is further configured to respond to a confirmation operation performed by the fit-out worker on the prompt information.

The display module 1103 is configured to display the first three-dimensional model, the second three-dimensional model, and the location node that fails to be matched, based on the confirmation operation.

In an optional implementation, the display module 1103 is further configured to display a first house model and a second house model. The first house model includes the first three-dimensional model, and the second house model includes the second three-dimensional model.

In an optional implementation, the processing module 1102 is further configured to: respond to a first rotation operation performed by the fit-out worker on the first house model, and display the first house model from different angles of view based on the first rotation operation; or the processing module 1102 is further configured to: respond to a second rotation operation performed by the fit-out worker on the second house model, and display the second house model from different angles of view based on the second rotation operation.

In an optional implementation, the second location information and the first location information are obtained in at least one of the following locating manners: ultra-wideband UWB, ultrasonic, wireless fidelity Wi-Fi, Bluetooth, radio frequency identification RFID, and ZigBee.

In an optional implementation, the first device information indicates the fit-out worker to configure a first home device collaboration scenario for the first house. The first home device collaboration scenario includes any one of a guest reception mode, a movie watching mode, an away mode, a sleep mode, a karaoke mode, a kids mode, a focus mode, a home mode, a work mode, or an elderly care mode. The any one mode includes collaboration of the plurality of first home devices.

The processing module 1102 is further used to configure a second home device collaboration scenario for the second house based on the first home device collaboration scenario. The second home device collaboration scenario is the same as or similar to the first home device collaboration scenario.

In an optional implementation, the method is applied to any one of a personal computer, a mobile phone, a tablet, and a terminal device dedicated to installation and maintenance.

In an optional implementation, the first home device and the second home device include at least two of a smart power strip, an electronic door lock, a smart speaker, an illumination device, a smart home appliance, a curtain control device, a home gateway, a projection device, a home robot, a sensing device, a gas control device, a smart alarm device, a smart electrical meter, and a smart water meter.

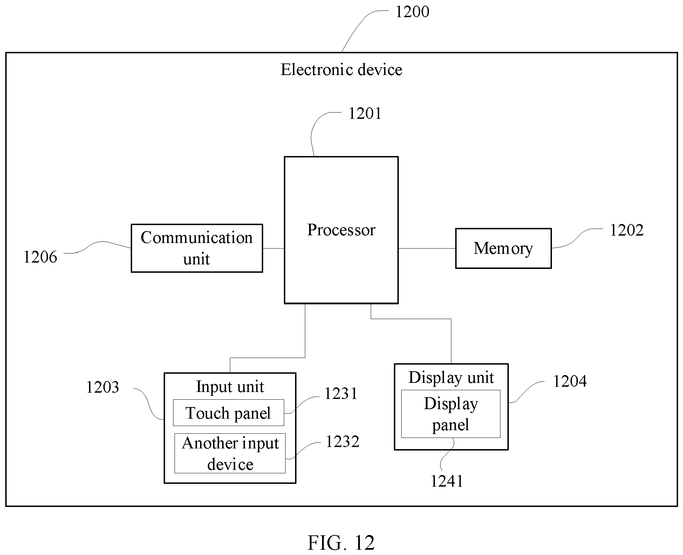

Refer to FIG. 12. An embodiment of this application further provides another electronic device. An electronic device 1200 is configured to perform a function performed by the installation and maintenance device in the foregoing method embodiments. In this embodiment of this application, an example in which the electronic device is a PC is used for description. The electronic device 1200 includes components such as a processor 1201, a memory 1202, an input unit 1203, a display unit 1204, a communication unit 1206, and the like. The memory 1202 may be configured to store a software program and a module. The processor 1201 runs the software program and the module stored in the memory 1202, to execute various function applications and data processing of an apparatus. The memory 1202 may include a high-speed random access memory, or may include a non-volatile memory, for example, at least one magnetic disk storage device, a flash memory device, or another volatile solid state storage device. The processor 1201 may be the processing apparatus mentioned in the embodiment corresponding to FIG. 11. Optionally, the processor 1201 includes but is not limited to various types of processors, such as a central processing unit (central processing unit, CPU), an image signal processor, and the like.

The input unit 1203 may be configured to: receive input digit or character information, and generate a key signal input related to a user setting and function control of the apparatus. Specifically, the input unit 1203 may include a touch panel 1231. The touch panel 1231, also referred to as a touchscreen, may collect a touch operation performed by a user on or near the touch panel 1231 (for example, an operation performed by the user on or near the touch panel 1231 by using any suitable object or accessory, such as a finger, a stylus, or the like). In addition to the touch panel 1231, the input unit 1130 may include another input device 1232. Specifically, the another input device 1232 may include but is not limited to one or more of a physical keyboard, a mouse, a joystick, and the like. In this embodiment, the input unit 1203 is configured to receive an operation input by a fit-out worker.

The display unit 1204 may be configured to display various types of image information. The display unit 1204 may include a display panel 1241. Optionally, the display panel 1241 may be configured by using a liquid crystal display, an organic light-emitting diode, or the like. In some embodiments, the touch panel 1231 and the display panel 1241 may be integrated to implement input and output functions of the apparatus. In this embodiment, the display unit 1204 is configured to display a first three-dimensional model, a second three-dimensional model, a matching result, and the like.

The communication unit 1206 is configured to: establish a communication channel, communicate with a home device, and receive location information sent by the home device. For example, the communication unit 1206 may include communication modules such as a wireless local area network module, a Bluetooth module, a baseband module, and the like, or may include a PLC communication module, a Wi-Fi communication module, a UWB communication module, an ultrasonic communication module, an RFID communication module, a ZigBee communication module, and the like. Optionally, various communication modules in the communication unit 1206 are generally in a form of an integrated circuit chip, and may be selectively combined. There is no need to include all the communication modules and corresponding antenna groups.

An embodiment of this application provides a computer-readable medium. The computer-readable storage medium is configured to store a computer program. When the computer program is run on a computer, the computer is enabled to perform the method performed by the installation and maintenance device in the foregoing method embodiments.

An embodiment of this application provides a chip. The chip includes a processor and a communication interface. The communication interface is, for example, an input/output interface, a pin, or a circuit. The processor is configured to read instructions to perform the method performed by the installation and maintenance device in the foregoing method embodiments.

An embodiment of this application provides a computer program product. When the computer program product is executed by a computer, the method performed by the installation and maintenance device in the foregoing method embodiments is implemented.

Optionally, the processor mentioned in any embodiment above is a general-purpose central processing unit (CPU), a microprocessor, or an application-specific integrated circuit (application-specific integrated circuit, ASIC).

The foregoing embodiments are merely intended for describing the technical solutions of this application rather than limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of this application.

**Claims**

1. A method for configuring device information of a home device, comprising:

   receiving a plurality of pieces of second location information of a plurality of second home devices installed in a second house;
   generating a second three-dimensional model based on the plurality of pieces of second location information, wherein the second three-dimensional model comprises a plurality of second location nodes that are in a correspondence with the pieces of second location information;
   performing matching on a first three-dimensional model and the second three-dimensional model to obtain a matching result, wherein the matching result comprises a first target location node and a second target location node that are successfully matched, the first three-dimensional model is generated based on a plurality of pieces of first location information of a plurality of first home devices in a first house, first device information has been configured for the first home devices, the first three-dimensional model comprises a plurality of first location nodes that are in a correspondence with the pieces of first location information, and a layout of the second house is the same as a layout of the first house, or a layout of the second house is symmetric to a layout of the first house; and
   configuring, based on the first device information of the first home device corresponding to the first target location node, second device information of the second home device corresponding to the second target location node.

2. The method according to claim 1, wherein the configuring, based on the first device information of the first home device corresponding to the first target location node, second device information of the second home device corresponding to the second target location node comprises:

copying the first device information of the first home device corresponding to the first target location node, to obtain first device information backup, and using the first device information backup as the second device information of the second home device corresponding to the second target location node.

**3.** The method according to claim 1 or 2, wherein before the performing matching on a first three-dimensional model and the second three-dimensional model, the method further comprises:

receiving the plurality of pieces of first location information of the plurality of first home devices installed in the first house; and
generating the first three-dimensional model based on the plurality of pieces of first location information.

**4.** The method according to any one of claims 1 to 3, wherein the first device information comprises a first installation location identifier, the first installation location identifier is used to describe an installation location of the first home device, and the method further comprises:
displaying the first three-dimensional model and a first installation location identifier corresponding to each first location node in the first three-dimensional model.

**5.** The method according to claim 1, wherein there are a plurality of second three-dimensional models, each second three-dimensional model corresponds to a second house, and when the matching result further comprises a location node that fails to be matched, the method further comprises:
generating prompt information, wherein the prompt information comprises an identifier of the second house.

**6.** The method according to claim 5, wherein the method further comprises:

responding to a confirmation operation performed by a fit-out worker on the prompt information; and
displaying the first three-dimensional model, the second three-dimensional model, and the location node that fails to be matched, based on the confirmation operation.

**7.** The method according to any one of claims 1 to 6, wherein the method further comprises:
displaying the first house model and the second house model, wherein the first house model comprises the first three-dimensional model, and the second house model comprises the second three-dimensional model.

**8.** The method according to claim 7, wherein the method further comprises:

responding to a first rotation operation performed by the fit-out worker on the first house model; and
displaying the first house model from different angles of view based on the first rotation operation;
or
responding to a second rotation operation performed by the fit-out worker on the second house model; and
displaying the second house model from different angles of view based on the second rotation operation.

**9.** The method according to any one of claims 1 to 8, wherein the second location information and the first location information are obtained in at least one of the following locating manners: ultra-wideband UWB, ultrasonic, wireless fidelity Wi-Fi, Bluetooth, radio frequency identification RFID, and ZigBee.

**10.** The method according to any one of claims 1 to 9, wherein the first device information indicates the fit-out worker to configure a first home device collaboration scenario for the first house, the first home device collaboration scenario comprises any one of a guest reception mode, a movie watching mode, an away mode, a sleep mode, a karaoke mode, a kids mode, a focus mode, a home mode, a work mode, or an elderly care mode, and the any one mode comprises collaboration of the plurality of first home devices; and
when or after the configuring, based on the first device information of the first home device corresponding to the first target location node, second device information of the second home device corresponding to the second target location node, the method further comprises:
configuring a second home device collaboration scenario for the second house based on the first home device collaboration scenario, wherein the second home device collaboration scenario is the same as or similar to the first home device collaboration scenario.

11. The method according to any one of claims 1 to 10, wherein the method is applied to any one of a personal computer, a mobile phone, a tablet, and a terminal device dedicated to installation and maintenance.

12. The method according to any one of claims 1 to 11, wherein the first home device and the second home device comprise at least two of a smart power strip, an electronic door lock, a smart speaker, an illumination device, a smart home appliance, a curtain control device, a home gateway, a projection device, a home robot, a sensing device, a gas control device, a smart alarm device, a smart electrical meter, and a smart water meter.

13. An electronic device, comprising a processor, wherein the processor is coupled to a memory, the memory is configured to store a program or instructions, and when the program or the instructions are executed by the processor, the electronic device is enabled to perform the method according to any one of claims 1 to 12.

14. A computer program product, wherein the computer program product comprises computer program code, and when the computer program code is executed by a computer, the computer is enabled to implement the method according to any one of claims 1 to 12.

15. A computer-readable storage medium, wherein the computer-readable storage medium is configured to store a computer program or instructions, and when the computer program or the instructions are executed, a computer is enabled to perform the method according to any one of claims 1 to 12.

Installed physical
illumination lamp

Status
change

Bright

Dim

Status control key

| Illumination lamp |
| Default device information |

| Smart power strip |
| Default device information |

| Fingerprint lock |
| Default device information |

| Smart speaker |
| Default device information |

Status control key

| Illumination lamp |
| **Living room Illumination lamp 1** |

| Smart power strip |
| Default device information |

| Fingerprint lock |
| Default device information |

| Smart speaker |
| Default device information |

FIG. 1

FIG. 2

FIG. 3A

$(x_2, y_2, z_2)$

$(x_3, y_3, z_3)$

R2

R3

$(x_1, y_1, z_1)$

R1

$(x, y, z)$

△ Base station          ◯ To-be-located object

FIG. 3B

FIG. 4

An installation and maintenance device receives a plurality of pieces of first location information of a plurality of first home devices installed in a first house, where first device information has been configured for the first home device — 501

↓

The installation and maintenance device generates a first three-dimensional model based on the plurality of pieces of first location information, where the first three-dimensional model includes a plurality of first location nodes that are in a correspondence with the pieces of first location information — 502

↓

The installation and maintenance device receives a plurality of pieces of second location information of a plurality of second home devices installed in a second house — 503

↓

The installation and maintenance device generates a second three-dimensional model based on the plurality of pieces of second location information, where the second three-dimensional model includes a plurality of second location nodes that are in a correspondence with the pieces of second location information — 504

↓

The installation and maintenance device performs matching on the first three-dimensional model and the second three-dimensional model to obtain a matching result, where the matching result includes a first target location node and a second target location node that are successfully matched — 505

↓

Configure, based on the first device information of the first home device corresponding to the first target location node, second device information of the second home device corresponding to the second target location node — 506

FIG. 5

```
                    ┌─────────────────────┐
                    │  Installation and   │
                    │    maintenance      │
                    │      device         │
                    │  ┌───────────────┐  │
                    │  │     PLC       │  │
                    │  │ communication │  │
                    │  │    module     │  │
                    │  └───────────────┘  │
                    └─────────────────────┘
```

Power line

```
┌─────────────────┐  ┌─────────────────┐  ┌─────────────────┐
│ ┌─────────────┐ │  │ ┌─────────────┐ │  │ ┌─────────────┐ │
│ │     PLC     │ │  │ │     PLC     │ │  │ │     PLC     │ │
│ │communication│ │  │ │communication│ │  │ │communication│ │
│ │   module    │ │  │ │   module    │ │  │ │   module    │ │
│ └─────────────┘ │  │ └─────────────┘ │  │ └─────────────┘ │
│   Home device   │  │   Home device   │  │   Home device   │
└─────────────────┘  └─────────────────┘  └─────────────────┘
```

FIG. 6

○ Location node

FIG. 7A

First three-dimensional model

Second three-dimensional model

○ Location node

FIG. 7B

Matched

Matched

Matched

Matched

Matched

Local vertex   ○ Location node

FIG. 7C

Configuration for house 201 succeeds

Configuration for house 301 succeeds

Configuration for house 401 succeeds

Configuration for house 501 fails

Configuration for house 601 fails

⋮

xxxxxxxxxxxxxx

FIG. 8

First three-dimensional model

First location node C

Second three-dimensional model

● Location node that fails to be matched    ○ Location node that is matched

FIG. 9

Configuration for
house 201 succeeds

Configuration for
house 301 succeeds

Configuration for
house 401 succeeds

Configuration for
house 501 fails

⋮

XXXXXXXXXXXXXX

House 101

Living room,
Downlight 3,
110

House 501

FIG. 10

1100

Installation and maintenance device

1101

Receiving
module

1102

Processing
module

1103

Display module

FIG. 11

1200

Electronic device

1201

Processor

Communication
unit

1206

Memory

1202

Input unit

1203

Touch panel

1231

Another input
device

1232

Display unit

Display
panel

1204

1241

FIG. 12

## INTERNATIONAL SEARCH REPORT

| | International application No. |
|---|---|
| | **PCT/CN2022/085700** |

| A. | CLASSIFICATION OF SUBJECT MATTER |
|---|---|

G05B 15/02(2006.01)i

According to International Patent Classification (IPC) or to both national classification and IPC

| B. | FIELDS SEARCHED |
|---|---|

Minimum documentation searched (classification system followed by classification symbols)

G05B15

Documentation searched other than minimum documentation to the extent that such documents are included in the fields searched

Electronic data base consulted during the international search (name of data base and, where practicable, search terms used)

CNABS; CNTXT; WPABS; ENTXTC; ENTXT; CNKI: 房屋, 房间, 户型, 布局, 相同, 相似, 对称, 设备, 配置, 位置, 方位, 复制, 批量, 三维, house, room, apartment, type, layout, same, similar, symmetry, equipment, device, facility, configuration, location, position, copy, batch, three dimensional, 3D

| C. | DOCUMENTS CONSIDERED TO BE RELEVANT | |
|---|---|---|

| Category* | Citation of document, with indication, where appropriate, of the relevant passages | Relevant to claim No. |
|---|---|---|
| X | CN 109218085 A (SHENZHEN LUMIUNITED TECHNOLOGY CO., LTD.) 15 January 2019 (2019-01-15)<br>description, paragraphs 28-103, and figures 1-13 | 1-15 |
| X | CN 112015095 A (SHENZHEN ORVIBO TECHNOLOGY CO., LTD.) 01 December 2020 (2020-12-01)<br>description, paragraphs 29-40, and figures 1-2 | 1-15 |
| A | CN 109802860 A (NANJING BIANYU LIANDONG TECHNOLOGY CO., LTD.) 24 May 2019 (2019-05-24)<br>entire document | 1-15 |
| A | CN 109104341 A (XIAMEN LEELEN TECHNOLOGY CO., LTD.) 28 December 2018 (2018-12-28)<br>entire document | 1-15 |
| A | CN 111934961 A (SHENZHEN ORVIBO TECHNOLOGY CO., LTD.) 13 November 2020 (2020-11-13)<br>entire document | 1-15 |

☑ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **01 June 2022** | **17 June 2022** |

| Name and mailing address of the ISA/CN | Authorized officer |
|---|---|
| **China National Intellectual Property Administration (ISA/ CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

| International application No. |
|---|
| **PCT/CN2022/085700** |

**C.    DOCUMENTS CONSIDERED TO BE RELEVANT**

| Category* | Citation of document, with indication, where appropriate, of the relevant passages | Relevant to claim No. |
|---|---|---|
| A | CN 111913402 A (SHENZHEN ORVIBO TECHNOLOGY CO., LTD.) 10 November 2020 (2020-11-10)<br>    entire document | 1-15 |
| A | CN 110601931 A (HANGZHOU LIFESMART TECHNOLOGY CO., LTD.) 20 December 2019 (2019-12-20)<br>    entire document | 1-15 |
| A | CN 109407538 A (NANJING BIANYU LIANDONG TECHNOLOGY CO., LTD.) 01 March 2019 (2019-03-01)<br>    entire document | 1-15 |
| A | CN 112100705 A (ALIBABA GROUP HOLDING LIMITED) 18 December 2020 (2020-12-18)<br>    entire document | 1-15 |
| A | US 2015271669 A1 (PANASONIC CORP.) 24 September 2015 (2015-09-24)<br>    entire document | 1-15 |
| A | US 2018120793 A1 (CARRIER CORP.) 03 May 2018 (2018-05-03)<br>    entire document | 1-15 |

Form PCT/ISA/210 (second sheet) (January 2015)

**INTERNATIONAL SEARCH REPORT**
Information on patent family members

International application No.

**PCT/CN2022/085700**

| Patent document cited in search report | | | Publication date (day/month/year) | Patent family member(s) | | | Publication date (day/month/year) |
|---|---|---|---|---|---|---|---|
| CN | 109218085 | A | 15 January 2019 | CN | 109218085 | B | 19 October 2021 |
| CN | 112015095 | A | 01 December 2020 | None | | | |
| CN | 109802860 | A | 24 May 2019 | None | | | |
| CN | 109104341 | A | 28 December 2018 | CN | 109104341 | B | 19 March 2021 |
| CN | 111934961 | A | 13 November 2020 | CN | 111934961 | B | 22 February 2022 |
| CN | 111913402 | A | 10 November 2020 | None | | | |
| CN | 110601931 | A | 20 December 2019 | CN | 110601931 | B | 07 December 2021 |
| CN | 109407538 | A | 01 March 2019 | None | | | |
| CN | 112100705 | A | 18 December 2020 | None | | | |
| US | 2015271669 | A1 | 24 September 2015 | JP | WO2015001772 | A1 | 23 February 2017 |
| | | | | WO | 2015001772 | A1 | 08 January 2015 |
| | | | | JP | 6351513 | B2 | 04 July 2018 |
| | | | | US | 9538375 | B2 | 03 January 2017 |
| US | 2018120793 | A1 | 03 May 2018 | WO | 2016154326 | A1 | 29 September 2016 |
| | | | | EP | 3274934 | A1 | 31 January 2018 |
| | | | | CN | 107667384 | A | 06 February 2018 |
| | | | | US | 10928785 | B2 | 23 February 2021 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110614552